# EUROPEAN PATENT APPLICATION

(11) **EP 4 016 261 A1**
(43) Date of publication of application: **22.06.2022**
(21) Application number: 21214256.6
(22) Date of filing: 14.12.2021
(51) Int. Cl.: G06F 3/041, G06F 3/044, G06F 3/046

(54) **DISPLAY APPARATUS**

(30) Priority: 15.12.2020 KR 20200175128
(71) Applicant: Samsung Display Co., Ltd., Yongin-si, Gyeonggi-do 17113 (KR)
(72) Inventor: Jung, Sung Ki, 504-2901 Tangjeong-myeon, Asan-si, Chungcheongnam-do (KR); Choi, Eun Gil, 105-1304 Cheonan-si, Chungcheongnam-do (KR); Gu, Da Som, Tangjeong-myeon, Asan-si, Chungcheongnam-do (KR); Kim, Yun Jae, 116-602 Cheonan-si, Chungcheongnam-do (KR); Shin, Jai Ku, C-4604 Hwaseong-si, Gyeonggi-do (KR); Jeon, Yong Chan, 103-301 Cheonan-si, Chungcheongnam-do (KR); Hwang, Hyun Been, 308-601 Yeongtong-gu, Suwon-si, Gyeonggi-do, (KR)
(74) Representative: Dr. Weitzel & Partner

(57) **Abstract**

A display device includes: a display panel comprising a display layer having a first display area, a second display area spaced apart from the first display area, and a third display area between the first and second display areas, and a touch sensor layer having a plurality of touch electrodes in the first, second, and third display areas on the display layer; a touch driver configured to drive the touch electrodes of the touch sensor layer; a digitizer layer below the display panel and overlapping with the first and second display areas, the digitizer layer comprising first electrode patterns and second electrode patterns; and an electromagnetic sensor driver configured to drive the first electrode patterns and the second electrode patterns of the digitizer layer to form a magnetic field in the digitizer layer.

## Description

### BACKGROUND

### 1. Field

The present invention relates to a display apparatus.

### 2. Description of the Related Art

As the information society has developed, the demand for display devices for displaying images has diversified. For example, display devices have been applied to various electronic devices such as smart phones, digital cameras, notebook computers, navigation systems, and smart televisions.

Recently, bendable or foldable display devices with bendable or foldable display areas have been developed to improve portability and provide relatively wide display screens.

Also, recent display devices support touch inputs made with parts of the human body (e.g., a finger) and touch inputs made with an electronic pen (e.g., a stylus pen). Display devices can detect touch inputs made with an electronic pen with the use of a digitizer layer and can thus sense touch inputs more precisely than when being able to detect only touch input made with parts of the human body. However, if the digitizer layer is located in the display area of a display device and is repeatedly bent or folded along with the display area, cracks may be generated so that the reliability of the display device may deteriorate over time and with repetitive bending.

The above information disclosed in this Background section is only for enhancement of understanding of the background and therefore the information discussed in this Background section does not necessarily constitute prior art.

### SUMMARY

The present invention provides a display apparatus with the features of claim 1. The dependent claims describe preferred embodiments.

The display apparatus of the present invention may be provided with or in form of a display device including a driver or driver components for driving the display device. According to another embodiment, the driver components are provided in a driver for driving the display device, wherein the driver is separate to the display device. Thus, according to the first embodiment, the display apparatus may be also termed as a display device, and in the second embodiment, the display apparatus may be also termed as a display system.

Aspects of some embodiments of the present disclosure include a display device respectively display apparatus capable of detecting touch input from a touch input member in a folding area.

However, embodiments according to the present disclosure are not restricted to those set forth herein. The above and other embodiments of the present disclosure will become more apparent to one of ordinary skill in the art to which the present disclosure pertains by referencing the detailed description of the present disclosure given below.

According to some embodiments of the present disclosure, a display apparatus, e.g. in form of a display device, comprises: a display panel comprising a display layer having a first display area, a second display area spaced apart from the first display area, and a third display area between the first and second display areas, and a touch sensor layer having a plurality of touch electrodes in the first, second, and third display areas on the display layer, a touch driver driving the touch electrodes of the touch sensor layer, a digitizer layer below the display panel to overlap with the first and second display areas, the digitizer layer comprising first electrode patterns and second electrode patterns, and an electromagnetic sensor driver driving the first electrode patterns and the second electrode patterns of the digitizer layer to form a magnetic field in the digitizer layer. According to some or all embodiments disclosed herein, the third display area may be bendable or foldable, and the first and second display areas may be non-bendable and non-foldable, that is rigid.

According to an embodiment, the digitizer layer may only be positioned outside of the third display area, that is the digitizer layer may not overlap with the third display area.

According to some embodiments, the display apparatus, e.g. in form of a display device, may further comprise a main processor comparing first coordinate data of a touch input member, which is output from the electromagnetic sensor driver, and second coordinate data of the touch input member, which is output from the touch driver to generate corrected coordinate data. According to a preferred embodiment, the main processor may use the first coordinate data of the touch input member to generate the corrected coordinate date, that is the corrected coordinate data may correspond to the first coordinate data at least in a region of the display area in which the touch sensor layer respectively a touch electrode thereof and the digitizer layer respectively electrode patterns thereof is present.

According to some embodiments, the main processor may compare first coordinate data detected from a first overlapping sensing area, which is part of the first display area adjacent to the third display area, or detected from a second overlapping sensing area, which is part of the second display area adjacent to the third display area, and the second coordinate data to generate the corrected coordinate data.

According to some embodiments, in a case where the electromagnetic sensor driver outputs first coordinate data from a first electromagnetic sensing area, which accounts for the entire first display area except for the first overlapping sensing area, and then the touch driver outputs second coordinate data from the first overlapping sensing area, the main processor may correct the second coordinate data based on the first coordinate data.

According to some embodiments, in a case where the main processor generates corrected coordinate data from the first overlapping sensing area and then the touch driver outputs second coordinate data from the third display area, the main processor may correct the second coordinate data based on the corrected coordinate data.

According to some embodiments, in a case where the main processor generates corrected coordinate data from the third display area and then the electromagnetic sensor driver outputs first coordinate data from the second overlapping sensing area, the main processor may correct the first coordinate data based on the corrected coordinate data.

According to some embodiments, in a case where the touch driver outputs second coordinate data from the third display area and then the electromagnetic sensor driver outputs first coordinate data from the second overlapping sensing area, the main processor may correct the first coordinate data based on the second coordinate data.

According to some embodiments, in a case where the main processor generates corrected coordinate data from the second overlapping sensing area and then the electromagnetic sensor driver outputs first coordinate data from a second electromagnetic sensing area, which accounts for the entire second display area except for the second overlapping sensing area, the main processor may correct the first coordinate data based on the corrected coordinate data.

According to some embodiments, the touch electrodes may comprise a plurality of driving electrodes and a plurality of sensing electrodes insulated from the driving electrodes. The first display area may comprise a first overlapping sensing area adjacent to the third display area, and a first electromagnetic sensing area, which accounts for the entire first display area except for the first overlapping sensing area. The second display area may comprise a second overlapping sensing area adjacent to the third display area, and a second electromagnetic sensing area, which accounts for the entire second display area except for the second overlapping sensing area. The touch sensor layer may comprise: first touch driving lines connected between the touch driver and driving electrodes in the first electronic sensing area, second touch driving lines connected between the touch driver and driving electrodes in the second electromagnetic sensing area, and third touch driving lines connected between the touch driver and driving electrodes in each of the first overlapping sensing area, the second overlapping sensing area, and the third display area.

According to some embodiments, the touch driver may provide first touch driving signals to the first touch driving lines, the second touch driving lines, and the third touch driving lines to detect a touch of the body of a user, and the touch driver may provide second touch driving signals to the third touch driving lines to detect a touch of the touch input member.

According to some embodiments, the first touch driving signals may be pulse signals having a first frequency, and the second touch driving signals may be pulse signals having a second frequency different from the first frequency.

According to some embodiments, the first touch driving signals may be pulse signals having a first frequency, and the second touch driving signals may be reference signals having a uniform voltage.

According to some embodiments, the touch input member may comprise a battery charged in the first and second display areas, and consumes power in the first overlapping sensing area, the second overlapping sensing area, and the third display area.

According to some embodiments, the display apparatus, e.g. in form of a display device, may further comprise: a shielding member below the digitizer layer to overlap with the first and second display areas, the shielding member shielding a magnetic field from the digitizer layer; and a heat dissipation member below the shielding member to overlap with the first and second display areas.

According to some embodiments, the digitizer layer may comprise a base layer having a first surface that supports the first electrode patterns and a second surface that supports the second electrode patterns. The first electrode patterns may extend in a first direction, and the second electrode patterns may extend in a second direction intersecting the first direction.

According to some embodiments of the present disclosure, a display apparatus, e.g. in form of a display device, comprises: a display panel comprising a first display area, a second display area spaced apart from the first display area, and a third display area between the first and second display areas, a touch sensor layer on the display panel to overlap with the first, second, and third display areas, the touch sensor layer comprising a plurality of touch electrodes, a touch driver driving the touch electrodes of the touch sensor layer, a digitizer layer below the display panel to overlap with the first and second display areas, the digitizer layer comprising first electrode patterns and second electrode patterns, and an electromagnetic sensor driver driving the first electrode patterns and the second electrode patterns of the digitizer layer to form a magnetic field in the digitizer layer.

According to some embodiments, the display apparatus, e.g. in form of a display device, may further comprise: a shielding member below the digitizer layer to overlap with the first and second display areas, the shielding member shielding a magnetic field from the digitizer layer, and a heat dissipation member below the shielding member to overlap with the first and second display areas.

According to some embodiments of the present disclosure, a display apparatus, e.g. in form of a display device, comprises: a display panel comprising a display layer having a first display area, a second display area spaced apart from the first display area, and a third display area between the first and second display areas, and a touch sensor layer having a plurality of touch electrodes in the first, second, and third display areas on the display layer, a touch driver driving the touch electrodes of the touch sensor layer, a digitizer layer below the display panel to overlap with the first and second display areas, the digitizer layer comprising first electrode patterns and second electrode patterns, and an electromagnetic sensor driver driving the first electrode patterns and the second electrode patterns of the digitizer layer to form a magnetic field in the digitizer layer. The first display area comprises a first overlapping sensing area adjacent to the third display area, and a first electromagnetic sensing area, which accounts for the entire first display area except for the first overlapping sensing area. The second display area comprises a second overlapping sensing area adjacent to the third display area, and a second electromagnetic sensing area, which accounts for the entire second display area except for the second overlapping sensing area. The electromagnetic sensor driver detects a touch of a touch input member from the first and second display areas. The touch driver detects a touch of the touch input member from the first overlapping sensing area, the second overlapping sensing area, and the third display area.

According to some embodiments, the display apparatus, e.g. in form of a display device, may further comprise a main processor comparing first coordinate data from the first and second overlapping sensing areas, which is output from the electromagnetic sensor driver, and second coordinate data from the first and second overlapping sensing areas, which is output from the touch driver to generate corrected coordinate data.

According to some embodiments, in a case where the electromagnetic sensor driver outputs first coordinate data from the first electromagnetic sensing area and then the touch driver outputs second coordinate data from the first overlapping sensing area, the main processor may correct the second coordinate data based on the first coordinate data.

According to some embodiments, in a case where the main processor generates corrected coordinate data from the first overlapping sensing area and then the touch driver outputs second coordinate data from the third display area, the main processor may correct the second coordinate data based on the corrected coordinate data.

According to some embodiments, in a case where the main processor generates corrected coordinate data from the third display area and then the electromagnetic sensor driver outputs first coordinate data from the second overlapping sensing area, the main processor may correct the first coordinate data based on the corrected coordinate data.

According to some embodiments, in a case where the touch driver outputs second coordinate data from the third display area and then the digitizer layer outputs first coordinate data from the second overlapping sensing area, the main processor may correct the first coordinate data based on the second coordinate data.

According to some embodiments of the present disclosure, a display apparatus, e.g. in form of a display system, comprises: a display device displaying an image, and a driver driving the display device. The display device comprises: display panel comprising a display layer having a first display area, a second display area spaced apart from the first display area, and a third display area between the first and second display areas, and a touch sensor layer having a plurality of touch electrodes in the first, second, and third display areas on the display layer, and a digitizer layer below the display panel and overlapping with the first and second display areas, the digitizer layer comprising first electrode patterns and second electrode patterns. The driver comprises: a touch driver configured to drive the touch electrodes of the touch sensor layer, and an electromagnetic sensor driver configured to drive the first electrode patterns and the second electrode patterns of the digitizer layer to form a magnetic field in the digitizer layer.

According to some embodiments of the present disclosure, a display apparatus, e.g. in form of a display system, comprises: a display device displaying an image, and a driver driving the display device. The display device comprises: a display panel comprising a display layer having a first display area, a second display area spaced apart from the first display area, and a third display area between the first and second display areas, and a touch sensor layer having a plurality of touch electrodes in the first, second, and third display areas on the display layer, and a digitizer layer below the display panel to overlap with the first and second display areas, the digitizer layer comprising first electrode patterns and second electrode patterns. The driver comprises: a touch driver driving the touch electrodes of the touch sensor layer, and an electromagnetic sensor driver configured to drive the first electrode patterns and the second electrode patterns of the digitizer layer to form a magnetic field in the digitizer layer. The first display area comprises a first overlapping sensing area adjacent to the third display area, and a first electromagnetic sensing area, which accounts for an entirety of the first display area except for the first overlapping sensing area, the second display area comprises a second overlapping sensing area adjacent to the third display area, and a second electromagnetic sensing area, which accounts an entirety of the second display area except for the second overlapping sensing area, the electromagnetic sensor driver is configured to detect a touch of a touch input member from the first and second display areas, and the touch driver is configured to detect a touch of the touch input member from the first overlapping sensing area, the second overlapping sensing area, and the third display area.

According to the aforementioned and other embodiments of the present disclosure, a display panel may include first and second display areas, which are not folded, and a third display area, which is located between the first and second display areas and is not folded. A digitizer layer may detect the touch of a touch input member from the first and second display areas, and a touch sensor layer may detect the touch of the touch input member from the third display area, a first overlapping sensing area, which is part of the first display area adjacent to the third display area, and a second overlapping sensing area, which is part of the second display area adjacent to the third display area. A main processor may generate corrected coordinate data by comparing touch coordinate data from the digitizer layer and touch coordinate data from the touch sensor layer. Thus, even if the digitizer layer is not located in a folding area, a display device can relatively improve the touch sensitivity for the touch input member in the folding area by synchronizing the touch coordinate data from the digitizer layer and the touch coordinate data from the touch sensor layer.

According to an embodiment, the main processor may be configured to generate corrected coordinate data as follows: If a touch input member is in contact with, or approaches, the first point in an electromagnetic sensing area, that is the first display area or the second display area, and then moves into the direction of the non-electromagnetic sensing area, that is the third display area, which is output from the electromagnetic sensor driver as a first coordinate data and from the touch driver as a second coordinate data, the second coordinate data is corrected to correspond to the first coordinate data. If however, the touch input member is in contact with, or approaches, a first point in the non-electromagnetic sensing area, that is the third display area, and then moves into an electromagnetic sensing area, that is the first display area or the second display area, which is output from the touch input member as second coordinate data and from the electromagnetic sensor driver as first coordinate data, then the first coordinate date (output from the electromagnetic sensor driver) is corrected to correspond to the second coordinate data to form the corrected coordinate data. If the touch input member moves from the first display area via the third display area into the second display area or vice versa, which again is output from the electromagnetic sensor driver as first coordinate data and the touch driver as second coordinate data, the second coordinate data may be corrected to correspond to the first coordinate data within the display area from which the movement originates and the first coordinate data from the display area (electromagnetic sensing area) into which the touch input member moves may be corrected to correspond to the mentioned corrected coordinate data. Thereby, the correction may be provided such that during the correction the whole movement line of the touch input member is jointly displaced such that in an overlapping region of the touch sensor layer and the digitizer layer the coordinate data are brought into alignment respectively become equal.

According to an embodiment, the invention refers to a method of correcting coordinate data as disclosed herein.

Other characteristics and embodiments may be apparent from the following detailed description, the drawings, and the claims.

### BRIEF DESCRIPTION OF THE DRAWINGS

The above and other embodiments and characteristics of the present disclosure will become more apparent by describing in more detail aspects of some embodiments thereof with reference to the attached drawings, in which:
FIG. 1 is a perspective view of a display device according to some embodiments of the present disclosure;
FIG. 2 is a perspective view of the display device of FIG. 1 in its folded state;
FIG. 3 is an exploded perspective view of the display device of FIG. 1;
FIG. 4 is a cross-sectional view taken along the line I-I' of FIG. 3;
FIG. 5 is a cross-sectional view of a display panel of the display device of FIG. 1;
FIG. 6 illustrates a touch sensor layer and a touch driver of the display device of FIG. 1;
FIG. 7 illustrates how the touch sensor layer and the touch driver of FIG. 6 are connected;
FIG. 8 is an exploded perspective view of a first digitizer layer of the display device of FIG. 1;
FIG. 9 is a cross-sectional view taken along the line II-II' of FIG. 8;
FIG. 10 is a block diagram illustrating a main processor, an electromagnetic sensor driver, the touch driver, and a display driver of the display device of FIG. 1;
FIG. 11 illustrates how to correct first coordinate data and second coordinate data according to some embodiments of the present disclosure;
FIG. 12 is a flowchart illustrating how to correct first coordinate data and second coordinate data according to the embodiments described with respect to FIG. 11;
FIG. 13 illustrates how to correct first coordinate data and second coordinate data according to some embodiments of the present disclosure;
FIG. 14 is a flowchart illustrating how to correct first coordinate data and second coordinate data according to the embodiments described with respect to FIG. 13;
FIG. 15 illustrates how the touch input member of the display device of FIG. 1 has its battery charged and consumes power;
FIG. 16 is an exploded perspective view of a display device according to some embodiments of the present disclosure; and
FIG. 17 is a cross-sectional view taken along the line III-III' of FIG. 16.

### DETAILED DESCRIPTION

In the following description, for the purposes of explanation, numerous details are set forth in order to provide a thorough understanding of various embodiments or implementations of the disclosure. As used herein "embodiments" and "implementations" are interchangeable words that are non-limiting examples of devices or methods employing one or more of the implementations or embodiments disclosed herein. It is apparent, however, that various embodiments may be practiced without these details or with one or more equivalent arrangements. In other instances, structures and devices may be shown in block diagram form in order to avoid unnecessarily obscuring various embodiments. Further, various embodiments may be different, but do not have to be exclusive. For example, shapes, configurations, and characteristics of an embodiment may be used or implemented in another embodiment without departing from the scope of the disclosure.

Unless otherwise specified, the illustrated embodiments are to be understood as providing features of varying detail of some or a number of ways in which the disclosure may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the disclosure.

The use of cross-hatching and/or shading in the accompanying drawings is generally provided to clarify boundaries between adjacent elements. As such, neither the presence nor the absence of cross-hatching or shading conveys or indicates any preference or requirement for materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be substantially perpendicular to one another, or may represent different directions that may not be perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

The terms "and" and "or" may be used in the conjunctive or disjunctive sense and may be understood to be equivalent to "and/or."

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (for example, rotated 90 degrees or about 90 degrees or at other orientations), and, as such, the spatially relative descriptors used herein interpreted accordingly.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

The terminology used herein is for the purpose of describing embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," "has," and/or "having," and/or variations thereof when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

For example, "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Some or a number of embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some or a number of functions and a processor (for example, one or more programmed microprocessors and associated circuitry) to perform other functions. Also, each block, unit, and/or module of some or a number of embodiments may be physically separated into two or more interacting and discrete blocks, units, and/or modules without departing from the scope of the disclosure. Further, the blocks, units, and/or modules of some or a number of embodiments may be physically combined into more complex blocks, units, and/or modules without departing from the scope of the disclosure.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

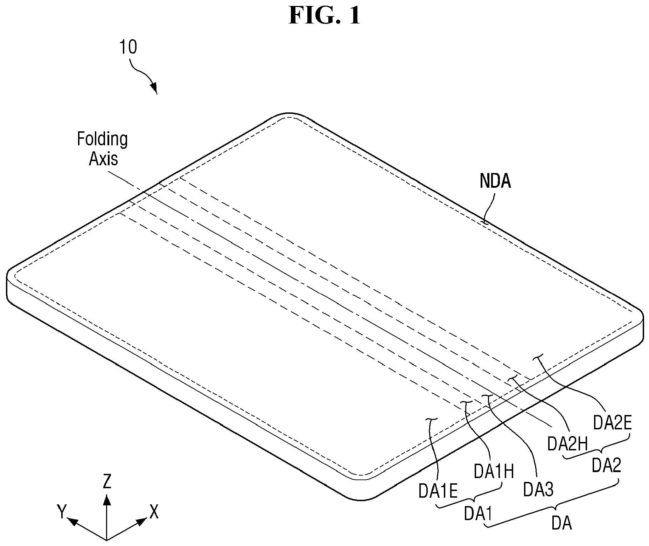

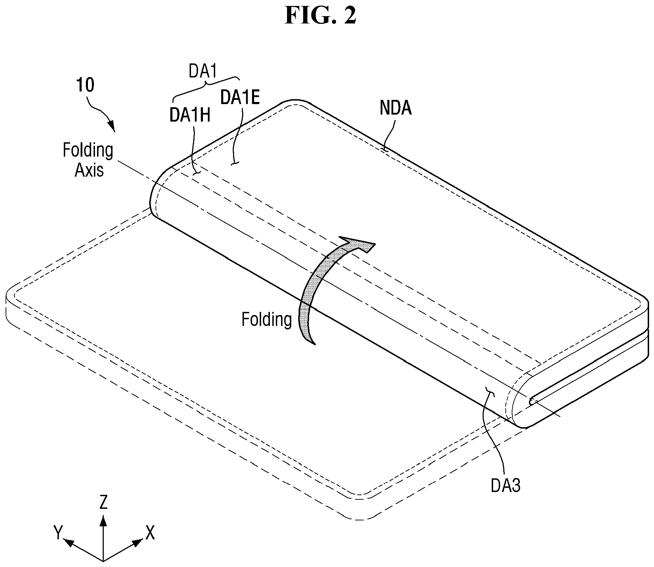

FIG. 1 is a perspective view of a display device according to some embodiments of the present disclosure, and FIG. 2 is a perspective view of the display device of FIG. 1 in its folded state.

Referring to FIGS. 1 and 2, a display device 10 may be applicable to a mobile electronic device such as a mobile phone, a smartphone, a tablet personal computer (PC), a mobile communication terminal, an electronic notepad, an electronic book (e-book), a portable multimedia player (PMP), a navigation device, or an ultramobile PC (UMPC).

A first direction (or an X-axis direction), which is parallel to one side of the display device 10, may be, for example, a horizontal direction of the display device 10. A second direction (or a Y-axis direction), which is parallel to the other side of the display device 10, may be, for example, a vertical direction of the display device 10. A third direction (or a Z-axis direction) may be a thickness direction of the display device 10.

The display device 10 may include a display area DA and a non-display area NDA. The planar shape of the display area DA may correspond to the planar shape of the display device 10. According to some embodiments, in which the display device 10 has a rectangular shape in a plan view, the display area DA may also have a rectangular shape in a plan view.

The display area DA may include a plurality of pixels and may display an image. The pixels may be arranged in row and column directions. The pixels may have a rectangular, rhombus, or square shape in a plan view, but embodiments according to the present disclosure are not limited thereto. Alternatively, the pixels may have a non-tetragonal polygonal shape, a circular shape, or an elliptical shape in a plan view.

The non-display area NDA may not include pixels and thus may not display images. According to some embodiments, the non-display area NDA may surround the display area DA, but embodiments according to the present disclosure are not limited thereto. According to some embodiments, the display area DA may be partially surrounded by the non-display area NDA.

The display device 10 may maintain its folded or unfolded state. According to some embodiments, the display device 10 may be in-folded so that the display area DA may be located on the inside of the display device 10, as illustrated in FIG. 2. In such embodiments, parts of the front surface of the display device 10 may face each other. According to some embodiments, the display device 10 may be out-folded so that the display area DA may be located on the outside of the display device 10. In such embodiments, parts of the rear surface of the display device 10 may face each other.

The display area DA may include first, second, and third display areas DA1, DA2, and DA3. The first display area DA1 may be arranged on the left side of the display area DA. The first display area DA1 may be arranged on one side of a folding axis "Folding Axis" axis "Folding Axis". The first display area DA1 may be a non-folding area.

The first display area DA1 may include a first overlapping sensing area DA1H and a first electromagnetic sensing area DA1E. The first overlapping sensing area DA1H may be adjacent to the third display area DA3. The first overlapping sensing area DA1H may be located on one side of the third display area DA3. The first electromagnetic sensing area DA1E may account for the entire first display area DA1 except for the first overlapping sensing area DA1H. According to some embodiments, the first electromagnetic sensing area DA1E may have a larger size than the first overlapping sensing area DA1H, but embodiments according to the present disclosure are not limited thereto.

The second display area DA2 may be located on the other side of the display area DA. According to some embodiments, the second display area DA2 may be located on the right side of the display area DA. The second display area DA2 may be located on the other side of the folding axis "Folding Axis". The second display area DA2 may be spaced apart from the first display area DA1 by the third display area DA3. The second display area DA2 may be a non-folding area.

The second display area DA2 may include a second overlapping sensing area DA2H and a second electromagnetic sensing area DA2E. The second overlapping sensing area DA2H may be adjacent to the third display area DA3. The second overlapping sensing area DA2H may be located on the other side of the third display area DA3. The second electromagnetic sensing area DA2E may account for the entire second display area DA2 except for the second overlapping sensing area DA2H. According to some embodiments, the second electromagnetic sensing area DA2E may have a larger size than the second overlapping sensing area DA2H, but embodiments according to the present disclosure are not limited thereto.

The third display area DA3 may be located between the first and second display areas DA1 and DA2 and may pass through the folding axis "Folding Axis". The third display area DA3 may be folded at a curvature (e.g., a set or predetermined curvature) along the folding axis "Folding Axis". The third display area DA3 may also be bent at a curvature (e.g., a set or predetermined curvature) along the folding axis "Folding Axis". According to some embodiments, the folding axis "Folding Axis" may pass through the center of the display area DA, but embodiments according to the present disclosure are not limited thereto.

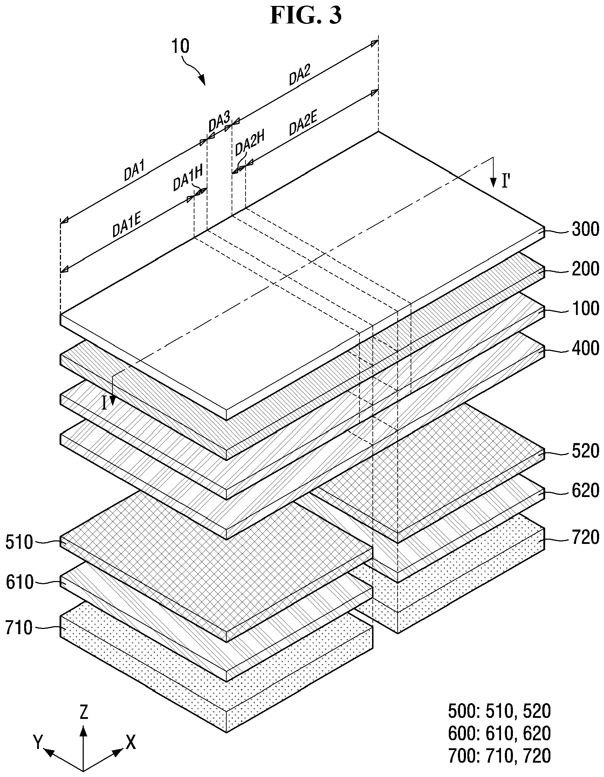

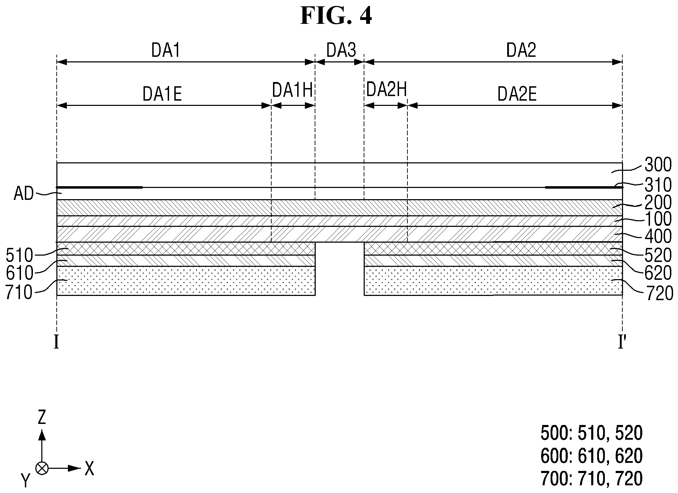

FIG. 3 is an exploded perspective view of the display device of FIG. 1, and FIG. 4 is a cross-sectional view taken along the line I-I' of FIG. 3.

Referring to FIGS. 3 and 4, the display device 10 includes a display panel 100, a polarizing film 200, a cover window 300, a panel protection film 400, a digitizer layer 500, a shielding member 600, and a heat dissipation member 700.

The display panel 100 may include the first, second, and third display areas DA1, DA2, and DA3. The display panel 100 may display an image through the first, second, and third display areas DA1, DA2, and DA3.

The display panel 100 may be a light-emitting display panel including light-emitting elements. According to some embodiments, the display panel 100 may be an organic light-emitting display panel using organic light-emitting diodes (OLEDs) that include organic light-emitting layers, a micro-light-emitting display panel using micro light-emitting diodes (mLEDs), a quantum-dot light-emitting display panel using quantum-dot light-emitting diodes, or an inorganic light-emitting display panel using inorganic light-emitting elements that include an inorganic semiconductor. The display panel 100 will hereinafter be described as being an organic light-emitting display panel, but embodiments according to the present disclosure are not limited thereto.

The polarizing film 200 may be located on the display panel 100. The top surface of the display panel 100 may be a display surface that displays images. The polarizing film 200 may be attached on the display panel 100 via an optically clear adhesive (OCA) film or an optically clear resin (OCR). According to some embodiments, the polarizing film 200 may include a linear polarizing plate and a phase retardation film such as a quarter wave (λ/4) plate. The phase retardation film and the linear polarizing plate may be sequentially stacked on the display panel 100.

The cover window 300 may be located on the polarizing film 200. The cover window 300 may be attached on the top surface of the polarizing film 200 via an adhesive member AD. According to some embodiments, the adhesive member AD may be an OCA film or an OCR, but embodiments according to the present disclosure are not limited thereto. The cover window 300 may include a transparent material such as glass or plastic. According to some embodiments, the cover window 300 may be ultra-thin glass (UTG) having a thickness of 0.1 mm or less or a transparent polyimide film, but embodiments according to the present disclosure are not limited thereto.

The cover window 300 may include a light-blocking layer 310, which is arranged along the edges of the bottom surface of the cover window 300. The light-blocking layer 310 may include a light-blocking material and may thus block light. According to some embodiments, the light-blocking layer 310 may include an inorganic black pigment such as carbon black or an organic black pigment.

The panel protection film 400 may be located below the display panel 100. According to some embodiments, the panel protection film 400 may be located below the display panel 100 to overlap with the first, second, and third display areas DA1, DA2, and DA3. According to some embodiments, the panel protection film 400 may be located only in the first and second display areas DA1 and DA2 so that the display panel 100 may be smoothly foldable.

The digitizer layer 500 may be located below the panel protection film 400. The digitizer layer 500 may include first and second digitizer layers 510 and 520. The first digitizer layer 510 may be located below the panel protection film 400 to overlap with the first display area DA1, and the second digitizer layer 520 may be located below the panel protection film 400 to overlap with the second display area DA2. Thus, as the first and second digitizer layers 510 and 520 are spaced apart from each other by the third display area DA3, the folding stress of the display device 10 can be reduced. Each of the first and second digitizer layers 510 and 520 may be attached to the bottom of the panel protection film 400 via an OCA film or an OCR.

Each of the first and second digitizer layers 510 and 520 may include a plurality of electrode patterns. Each of the first and second digitizer layers 510 and 520 may detect the approach or contact of a touch input member such as stylus pen that supports electromagnetic resonance (EMR) using a plurality of electrode patterns. Here, the stylus pen may include a coil and may output a radio frequency signal in response to a magnetic field or an electromagnetic signal.

According to some embodiments, each of the first and second digitizer layers 510 and 520 may generate a magnetic field or an electromagnetic signal on the front surface of the display device 10, and the touch input member may detect the magnetic field or the electromagnetic signal and emit a radio frequency signal. Each of the first and second digitizer layers 510 and 520 may detect touch coordinates, a touch angle, and touch pressure by receiving a radio frequency signal upon the approach or contact of the touch input member.

The shielding member 600 may be located below the digitizer layer 500. The shielding member 600 may include first and second shielding members 610 and 620. The first shielding member 610 may be located below the first digitizer layer 510 to overlap with the first display area DA1, and the second shielding member 620 may be located below the second digitizer layer 520 to overlap with the second display area DA2. Thus, as the first and second shielding members 610 and 620 are spaced apart from each other by the third display area DA3, the folding stress of the display device 10 can be reduced.

Each of the first and second shielding members 610 and 620 may include magnetic metal powder and may thus induce a magnetic field or an electromagnetic signal passing through the digitizer layer 500 into the first and second shielding members 610 and 620. Accordingly, the first and second shielding members 610 and 620 can reduce the emission of a magnetic field or an electromagnetic signal to the bottoms of the first and second shielding members 610 and 620.

The heat dissipation member 700 may be located below the shielding member 600. The heat dissipation member 700 may include first and second heat dissipation members 710 and 720. The first heat dissipation member 710 may be located below the first shielding member 610 to overlap with the first display area DA1, and the second heat dissipation member 720 may be located below the second shielding member 620 to overlap with the second display area DA2. Thus, as the first and second heat dissipation members 710 and 720 are spaced apart from each other by the third display area DA3, the folding stress of the display device 10 can be reduced.

Each of the first and second heat dissipation members 710 and 720 may include a film of a metal with excellent thermal conductivity such as copper, nickel, ferrite, or silver. Thus, heat generated by the display device 10 can be released to the outside of the display device 10 by the first and second heat dissipation members 710 and 720.

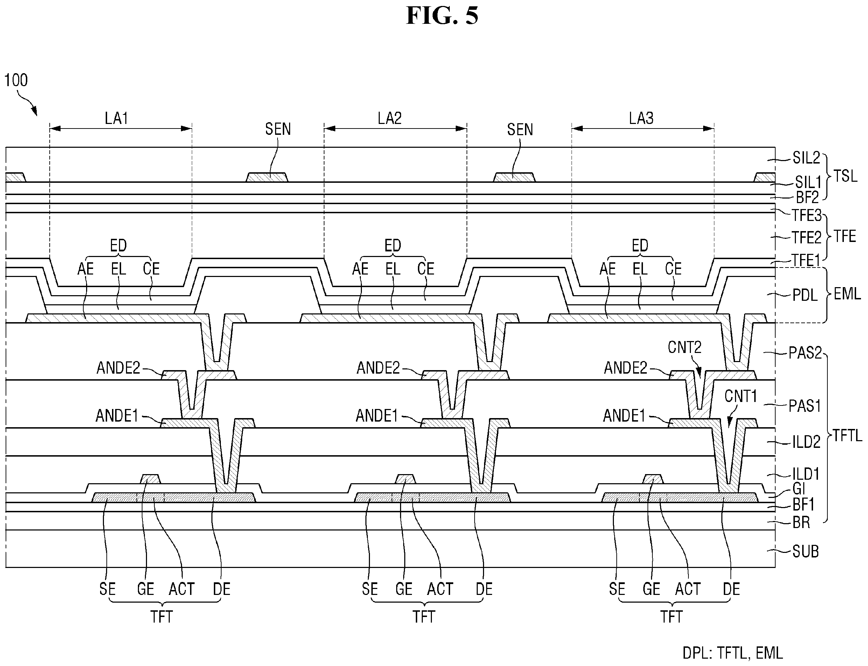

FIG. 5 is a cross-sectional view of the display panel 100 of the display device of FIG. 1.

Referring to FIG. 5, the display panel 100 may include a substrate SUB, a display layer DPL, an encapsulation layer TFE, and a touch sensor layer TSL.

The substrate SUB may be a base substrate or a base member and may support the display panel 100. According to some embodiments, the substrate SUB may include a flexible material that is easily bendable, foldable, or rollable. The substrate SUB may be a flexible substrate that is bendable, foldable, or rollable. According to some embodiments, the substrate SUB may include a flexible material and a rigid material.

The display layer DPL may be located on the substrate SUB. The display layer DPL may include a thin-film transistor layer TFTL and a light-emitting element layer EML.

The thin-film transistor layer TFTL may include a barrier layer BR, a first buffer layer BF1, thin-film transistors TFT, a gate insulating film G, a first interlayer insulating film ILD1, a second interlayer insulating film ILD2, first anode connecting electrodes ANDE1, a first passivation layer PAS1, second anode connecting electrodes ANDE2, and a second passivation layer PAS2.

The barrier layer BR may be located on the substrate SUB. The barrier layer BR may include at least one inorganic film capable of preventing the penetration of the air or moisture and may protect the thin-film transistor layer TFTL and the light-emitting element layer EML. According to some embodiments, the barrier layer BR may include a plurality of inorganic films that are alternately stacked.

The first buffer layer BF1 may be located on the barrier layer BR. The first buffer layer BF1 may include at least one inorganic film capable of preventing the penetration of the air or moisture. According to some embodiments, the first buffer layer BF1 may include a plurality of inorganic films that are alternately stacked.

The thin-film transistors TFT may be located on the first buffer layer BF1 and may form the pixel circuits of a plurality of pixels. According to some embodiments, the thin-film transistors TFT may be driving transistors or switching transistors. The thin-film transistors TFT may include semiconductor layers ACT, gate electrodes GE, source electrodes SE, and drain electrodes DE.

The semiconductor layers ACT, the source electrodes SE, and the drain electrodes DE may be located on the first buffer layer BF1. The semiconductor layers ACT may overlap with the gate electrodes GE in the thickness direction (or the Z-axis direction) and may be insulated from the gate electrodes GE by the gate insulating film GI. The source electrodes SE and the drain electrodes DE may be obtained by transforming the material of the semiconductor layers ACT into conductors.

The gate electrodes GE may be located on the gate insulating film GI. The gate electrodes GE may overlap with the semiconductor layers ACT with the gate insulating film GI interposed therebetween.

The gate insulating film GI may be located on the semiconductor layers ACT, the source electrodes SE, and the drain electrodes DE. According to some embodiments, the gate insulating film GI may cover the semiconductor layers ACT, the source electrodes SE, the drain electrodes DE, and the first buffer layer BF1 and may insulate the semiconductor layers ACT and the gate electrodes GE. The gate insulating film GI may include first contact holes CNT1, in which the first anode connecting electrodes ANDE1 are inserted.

The first interlayer insulating film ILD1 may be located on the gate electrodes GE. The first interlayer insulating film ILD1 may include the first contact holes CNT1, in which the first anode connecting electrodes ANDE1 are inserted.

The second interlayer insulating film ILD2 may be located on the first interlayer insulating film ILD1. The second interlayer insulating film ILD2 may include the first contact holes CNT1, in which the first anode connecting electrodes ANDE1 are inserted. The first contact holes CNT1 may penetrate the second interlayer insulating film ILD2, the first interlayer insulating film ILD1, and the gate insulating film GI.

The first anode connecting electrodes ANDE1 may be located on the second interlayer insulating film ILD2. The first anode connecting electrodes ANDE1 may be inserted in the first contact holes CNT1 to be connected to the drain electrodes DE Of the thin-film transistors TFT.

The first passivation layer PAS1 may be provided on the thin-film transistors TFT to protect the thin-film transistors TFT. The first passivation layer PAS1 may cover the first anode connecting electrodes ANDE1 and the second interlayer insulating film ILD2. The first passivation layer PAS1 may include second contact holes CNT2, in which the second anode connecting electrodes ANDE2 are inserted. According to some embodiments, the first passivation layer PAS1 may include an organic film, but the present disclosure is not limited thereto.

The second anode connecting electrodes ANDE2 may be located on the first passivation layer PAS1. The second anode connecting electrodes ANDE2 may be inserted in the second contact holes CNT2 to be connected to the first anode connecting electrodes ANDE1.

The second passivation layer PAS2 may be located on the first passivation layer PAS1 to cover the second anode connecting electrodes ANDE2 and the first passivation layer PAS1. The second passivation layer PAS2 may include contact holes that are passed through by first electrodes AE of light-emitting elements ED. According to some embodiments, the second passivation layer PAS2 may include an organic film, but embodiments according to the present disclosure are not limited thereto.

The light-emitting element layer EML may be located on the thin-film transistor layer TFTL. The light-emitting element layer EML may include the light-emitting elements ED and a pixel defining film PDL. Each of the light-emitting elements ED may include a first electrode AE, a light-emitting layer EL, and a second electrode CE.

First electrodes AE may be located on the second passivation layer PAS2. According to some embodiments, the first pixel electrodes AE may overlap with first, second, and third emission areas LA1, LA2, and LA3, which are defined by the pixel defining film PDL. The first electrodes AE may be connected to the drain electrodes DE of the thin-film transistors TFT via the first anode connecting electrodes ANDE1 and the second anode connecting electrodes ANDE2.

Light-emitting layers EL may be located on the first electrodes AE. The light-emitting layers EL may include hole injection layers, hole transport layers, emission layers, electron blocking layers, electron transport layers, and electron injection layers. According to some embodiments, the light-emitting layers EL may be organic light-emitting layers that are formed of an organic material, but the present disclosure is not limited thereto. In this example, as the thin-film transistors TFT apply a voltage (e.g., a set or predetermined voltage) to the first electrodes AE of the light-emitting elements ED and the second electrodes CE of the light-emitting elements ED receive a common voltage or a cathode voltage, holes and electrons may move to the organic light-emitting layers EL via the hole transport layers and the electron transport layers, respectively, and may combine together in the organic light-emitting layers EL, thereby emitting light.

A second electrode CE may be located on the light-emitting layers EL. According to some embodiments, the second electrode CE may be implemented as a common electrode provided for all pixels, rather than for each individual pixel. The second electrode CE may be located on the light-emitting layers EL, in the first, second, and third emission areas LA1, LA2, and LA3, and on the pixel-defining film PDL, in areas other than the first, second, and third emission areas LA1, LA2, and LA3.

The pixel defining film PDL may define the first, second, and third emission areas LA1, LA2, and LA3. The pixel defining film PDL may separate and insulate the first electrodes AE of the light-emitting elements ED from one another.

The encapsulation layer TFE may be located on the light-emitting element layer EML to cover the light-emitting elements ED. The encapsulation layer TFE may include at least one inorganic film and may prevent the penetration of oxygen or moisture into the light-emitting element layer EML. The encapsulation layer TFE may include first, second, and third encapsulation layers TFE1, TFE2, and TFE3.

The first encapsulation layer TFE1 may be located on the second electrode CE to cover the light-emitting elements ED. The first encapsulation layer TFE1 may include an inorganic film and may prevent the penetration of oxygen or moisture into the light-emitting element layer EML.

The second encapsulation layer TFE2 may be located on the first encapsulation layer TFE1 and may planarize the top of the first encapsulation layer TFE1. The second encapsulation layer TFE2 may include an organic film and may protect the light-emitting element layer EML from a foreign material such as dust.

The third encapsulation layer TFE3 may be located on the second encapsulation layer TFE2. The third encapsulation layer TFE3 may include an inorganic film and may prevent or reduce the penetration of oxygen or moisture into the light-emitting element layer EML.

The touch sensor layer TSL may be located on the encapsulation layer TFE. The touch sensor layer TSL may include a second buffer layer BF2, a first insulating film SIL1, touch electrodes SEN, and a second insulating film SIL2.

The second buffer layer BF2 may be located on the encapsulation layer TFE. The second buffer layer BF2 may have an insulating function and an optical function. According to some embodiments, the second buffer layer BF2 may include at least one inorganic film. Optionally, the second buffer layer BF2 may not be provided.

The first insulating film SIL1 may cover the second buffer layer BF2. The first insulating layer SIL1 may have an insulating function and an optical function. According to some embodiments, the first insulating layer SIL1 may include an inorganic film.

The touch electrodes SEN may be located on the first insulating layer SIL. The touch electrodes SEN may be arranged to not overlap with the first, second, and third emission areas LA1, LA2, and LA3, but to be positioned between the first, second, and third emission areas LA1, LA2, and LA3. Thus, the display device 10 can prevent the luminance of light emitted from the first, second, and third emission areas LA1, LA2, and LA3 from being reduced by the touch sensor layer TSL. The touch electrodes SEN may include driving electrodes and sensing electrodes. According to some embodiments, the driving electrodes may receive touch driving signals from a touch driver, and the sensing electrodes may provide touch sensing signals to the touch driver.

The second insulating layer SIL2 may cover the touch electrodes SEN and the first insulating layer SIL1. The second insulating layer SIL2 may have an insulating function and an optical function. The second insulating layer SIL2 may include an inorganic film.

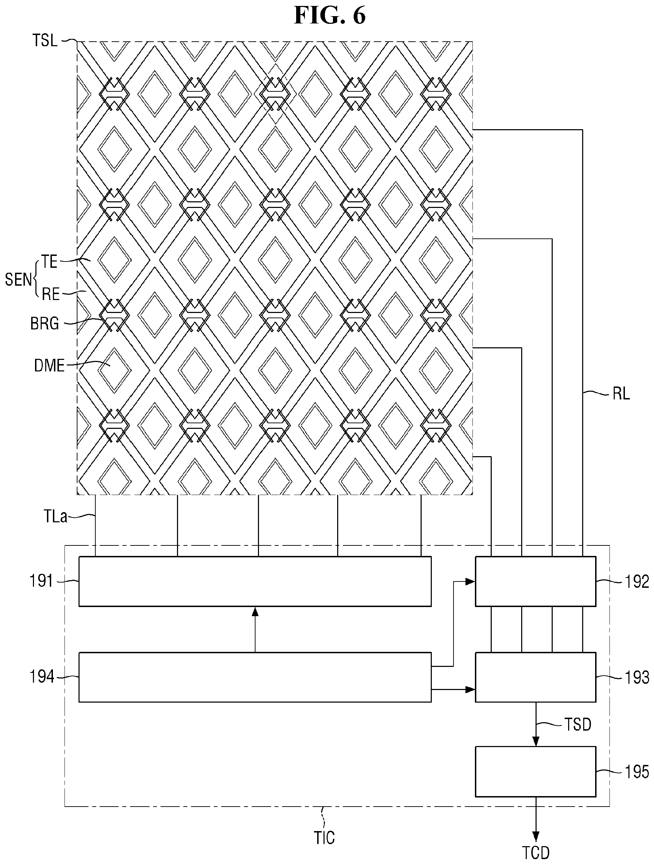

FIG. 6 illustrates the touch sensor layer and the touch driver of the display device of FIG. 1.

Referring to FIG. 6, the touch sensor layer TSL may include a plurality of touch electrodes SEN and a plurality of dummy electrodes DME. The touch electrodes SEN may form mutual capacitance or self-capacitance to detect the touch of an object or a user. The touch electrodes SEN may include a plurality of driving electrodes TE and a plurality of sensing electrodes RE.

The driving electrodes TE may be arranged in the first direction (or the X-axis direction) and in the second direction (or the Y-axis direction). The driving electrodes TE may be spaced apart from one another in the first direction (or the X-axis direction) and in the second direction (or the Y-axis direction). Each of pairs of adjacent driving electrodes TE in the second direction (or the Y-axis direction) may be electrically connected via bridge electrodes BRG. The driving electrodes TE may be connected to a touch driver TIC via touch driving lines TL.

The bridge electrodes BRG may be bent at least once. According to some embodiments, the bridge electrodes BRG may be in the shape of angle brackets (i.e., "<" and ">"). That is, according to some embodiments, a pair of the bridge electrodes BRG may have opposing points that face away from each other in a plan view, with corresponding straight portions that connect from a driving electrode TE above to the point, and then to a driving electrode TE below. The planar shape of the bridge electrodes BRG, however, is not particularly limited, and the bridge electrodes BRG may have any other suitable shape consistent with the present disclosure to connect adjacent driving electrodes TE. Each of the pairs of adjacent driving electrodes TE in the second direction (or the Y-axis direction) may be connected by multiple bridge electrodes BRG, and thus, even if one of the multiple bridge electrodes BRG is disconnected, the driving electrodes TE can be stably connected via the other nondisconnected bridge electrodes BRG. Each of the pairs of adjacent driving electrodes TE in the second direction (or the Y-axis direction) may be connected by two bridge electrodes BRG, but the number of bridge electrodes BRG is not particularly limited.

The bridge electrodes BRG may be located in a different layer from the driving electrodes TE and the sensing electrodes RE. Each of pairs of adjacent sensing electrodes RE in the first direction (or the X-axis direction) may be electrically connected via connectors located in the same layer as the driving electrodes TE or the sensing electrodes RE, and each of the pairs of adjacent driving electrodes TE in the second direction (or the Y-axis direction) may be electrically connected via bridge electrodes BRG arranged in a different layer from the driving electrodes TE or the sensing electrodes RE. Thus, even if the bridge electrodes BRG overlap with the sensing electrodes RE in the third direction (or the Z-axis direction), the driving electrodes TE can be insulated from the sensing electrodes RE, and vice versa. Mutual capacitance may be formed between the driving electrodes TE and the sensing electrodes RE.

The sensing electrodes RE may extend in the first direction (or the X-axis direction) and may be spaced apart from one another in the second direction (or the Y-axis direction). The sensing electrodes RE may be arranged in the first direction (or the X-axis direction) and the second direction (or the Y-axis direction), and each of the pairs of adjacent sensing electrodes RE in the first direction (or the X-axis direction) may be electrically connected by a connector. The sensing electrodes RE may be connected to the touch driver TIC via touch sensing lines RL.

Each of the dummy electrodes DME may be surrounded by the driving electrodes TE or the sensing electrodes RE. Each of the dummy electrodes DME may be spaced apart from, and insulated by, the driving electrodes TE or the sensing electrodes RE. Thus, the dummy electrodes DME may be electrically floated. Insofar, the dummy electrodes may alternatively be termed as floating electrodes.

The touch driver TIC may include a driving signal output unit 191, a sensing circuit unit 192, an analog-to-digital conversion unit 193, a touch control unit 194, and a touch data compensation unit 195. For example, the touch driver TIC may be embedded in the display device. For another example, the touch driver TIC may be a set device driving the display device. In this case, a display system may include the display device and a driver, the driver may include the touch driver TIC.

The driving signal output unit 191 may be connected to the driving electrodes TE via the touch driving lines TL (that is TLa, wherein a is an integer). The driving signal output unit 191 may provide touch driving signals to the driving electrodes TE. Each of the touch driving signals may have multiple driving pulses. The driving signal output unit 191 may provide the touch driving signals to the touch driving lines in an order (e.g., a set or predetermined order). According to some embodiments, the driving signal output unit 191 may sequentially output the touch driving signals to the driving electrodes TE in the order from driving electrodes TE on one side of the touch sensor layer TSL to driving electrodes TE on the other side of the touch sensor layer TSL.

The sensing circuit unit 192 may be connected to the sensing electrodes RE via the touch sensing lines RL. The sensing circuit unit 192 may sense the mutual capacitances between the driving electrodes TE and the sensing electrodes RE via the touch sensing lines RL.

Alternatively, the driving signal output unit 191 may provide the touch driving signals to the touch electrodes TE, and the sensing circuit unit 192 may provide the touch driving signals to the sensing electrodes RE. In this case, the driving signal output unit 191 may sense charge variations in the touch electrodes TE, and the sensing circuit unit 192 may sense charge variations in the sensing electrodes RE. Thus, the driving signal output unit 191 may sense self-capacitance variations in the touch electrodes TE, and the sensing circuit unit 192 may sense self-capacitance variations in the sensing electrodes RE.

The analog-to-digital conversion unit 193 may convert an output voltage from the sensing circuit unit 192 into touch sensing data TSD, which is digital data. The analog-to-digital conversion unit 193 may provide the touch sensing data TSD to the touch data compensation unit 195.

The touch control unit 194 may control the driving timings of the driving signal output unit 191, the sensing circuit unit 192, and the analog-to-digital conversion unit 193. The touch control unit 194 may output timing signals for the synchronization of the driving signal output unit 191, the sensing circuit unit 192, and the analog-to-digital conversion unit 193 to the driving signal output unit 191, the sensing circuit unit 192, and the analog-to-digital conversion unit 193.

The touch data compensation unit 195 may receive the touch sensing data TSD from the analog-to-digital conversion unit 193. The touch data compensation unit 195 may calculate the presence of touch input from the user and the touch coordinates of the touch input by analyzing the touch sensing data TSD.

The touch driver TIC may calculate the presence of touch input from the touch input member such as a stylus pen and the touch coordinates of the touch input. The touch data compensation unit 195 may analyze touch sensing data TSD from the touch input member and may output second coordinate data TCD.

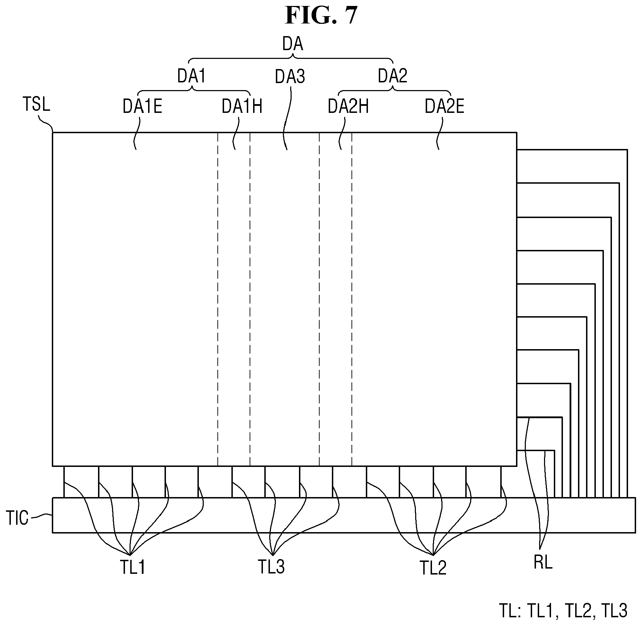

FIG. 7 illustrates how the touch sensor layer and the touch driver of FIG. 6 are connected.

Referring to FIG. 7, the display area DA may include the first, second, and third display areas DA1, DA2, and DA3. The first display area DA1 may be arranged on one side of the display area DA. The first display area DA1 may be a non-folding area.

The first display area DA1 may include the first overlapping sensing area DA1H and the first electromagnetic sensing area DA1E. The first overlapping sensing area DA1H may be adjacent to the third display area DA3. The first overlapping sensing area DA1H may be located on one side of the third display area DA3. The first electromagnetic sensing area DA1E may account for the entire first display area DA1 except for the first overlapping sensing area DA1H.

The second display area DA2 may be located on the other side of the display area DA. The second display area DA2 may be spaced apart from the first display area DA1 by the third display area DA3. The second display area DA2 may be a non-folding area.

The second display area DA2 may include the second overlapping sensing area DA2H and the second electromagnetic sensing area DA2E. The second overlapping sensing area DA2H may be adjacent to the third display area DA3. The second overlapping sensing area DA2H may be located on the other side of the third display area DA3. The second electromagnetic sensing area DA2E may account for the entire second display area DA2 except for the second overlapping sensing area DA2H.

The third display area DA3 may be located between the first and second display areas DA1 and DA2 and may pass through the folding axis "Folding Axis". The third display area DA3 may be folded at a curvature (e.g., a set or predetermined curvature) along the folding axis "Folding Axis". The third display area DA3 may also be bent at a curvature (e.g., a set or predetermined curvature) along the folding axis "Folding Axis". According to some embodiments, the folding axis "Folding Axis" may pass through the center of the display area DA, but embodiments according to the present disclosure is not limited thereto. For example, according to some embodiments, the folding axis "Folding Axis" may be offset from the center of the display are DA, or may extend along an acute angle relative to a center line of the display area DA.

The driving electrodes TE of the touch sensor layer TSL may be located in the first, second, and third display areas DA1, DA2, and DA3. The driving electrodes TE may be connected to the touch driver TIC via the touch driving lines TL.

The driving electrodes TE located in the first electromagnetic sensing area DA1E may be connected to the touch driver TIC via first touch driving lines TL1. The driving electrodes TE located in the second electromagnetic sensing area DA2E may be connected to the touch driver TIC via second touch driving lines TL2. The driving electrodes TE located in each of the first overlapping sensing area DA1H, the second overlapping sensing area DA2H, and the third display area DA3 may be connected to the touch driver TIC via third touch driving lines TL3.

The touch driver TIC may provide first touch driving signals to the driving electrodes TE in the display area DA via the first touch driving lines TL1, the second touch driving lines TL2, and the third touch driving lines TL3 during a first period. Here, the first period may appear repeatedly in at least one frame, and the first touch driving signals may be pulse signals having a first frequency. The touch driver TIC may provide the first touch driving signals to the driving electrodes TE in the display area DA during the first period and may thus be able to detect the touch of the body (e.g., a user's finger) of the user.

The touch driver TIC may provide second touch driving signals to the driving electrodes TE in each of the first overlapping sensing area DA1H, the second overlapping sensing area DA2H, and the third display area DA3 via the third touch driving lines TL3 during a second period. Here, the second period may appear repeatedly in at least one frame. The second period may be included in the same frame as, or in a different frame from, the first period.

According to some embodiments, the second touch driving signals may be pulse signals having a second frequency, which is different from the first frequency. According to some embodiments, the second touch driving signals may be reference signals having a uniform voltage. In a case where the second touch driving signals are reference signals, the touch electrodes TE may receive pulse signals from the touch input member. The touch driver TIC may provide the second touch driving signals to the driving electrodes TE in each of the first overlapping sensing area DA1H, the second overlapping sensing area DA2H, and the third display area DA3 during the second period and may thus be able to detect touch input from the touch input member.

According to some embodiments, the number of touch electrodes SEN arranged per unit area may be the same in each of the first, second, and third display areas DA1, DA2, and DA3.

According to some embodiments, the number of touch electrodes SEN arranged per unit area may be greater in each of the first overlapping sensing area DA1H, the second overlapping sensing area DA2H, and the third display area DA3 than in each of the first and second electromagnetic sensing areas DA1E and DA2E. In this example, as the touch electrodes SEN are arranged relatively densely in each of the first overlapping sensing area DA1H, the second overlapping sensing area DA2H, and the third display area DA3, the touch sensitivity for the touch input member can be improved.

According to some embodiments, the number of touch electrodes SEN arranged per unit area may be smaller in each of the first overlapping sensing area DA1H, the second overlapping sensing area DA2H, and the third display area DA3 than in each of the first and second electromagnetic sensing areas DA1E and DA2E.

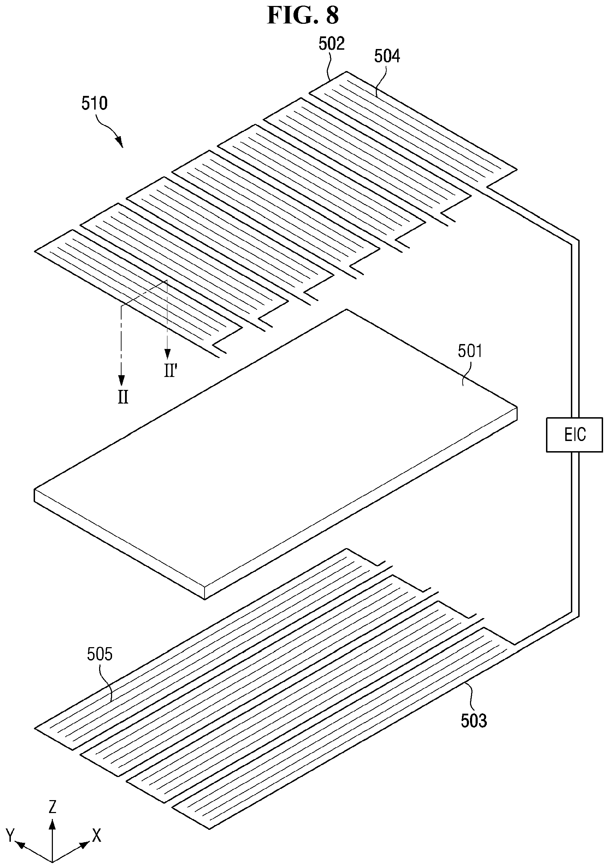

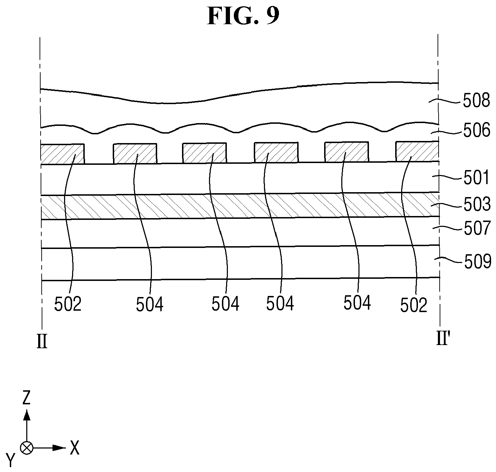

FIG. 8 is an exploded perspective view of the first digitizer layer of the display device of FIG. 1, and FIG. 9 is a cross-sectional view taken along the line II-II' of FIG. 8.

Referring to FIGS. 8 and 9, the first digitizer 510 includes a base layer 501, first electrode patterns 502, second electrode patterns 503, first dummy patterns 504, second dummy patterns 505, a first adhesive layer 506, a second adhesive layer 507, a first cover layer 508, and a second cover layer 509.

The base layer 501 may have flexibility and may include an insulating material. A first surface of the base layer 501 may support the first electrode patterns 502, and a second surface of the base layer 501 may support the second electrode patterns 503. According to some embodiments, the base layer 501 may include polyimide.

The first electrode patterns 502 and the first dummy patterns 504 may be located on the surface of the base layer 501. The first electrode patterns 502 may be arranged along the second direction (or the Y-axis direction). The first electrode patterns 502 may have a loop shape in a plan view, and both ends of each of the first electrode patterns 502 may be connected to an electromagnetic sensor driver EIC.

The second electrode patterns 503 and the second dummy patterns 505 may be located on the second surface of the base layer 501. The second electrode patterns 503 may be arranged along the first direction (or the X-axis direction). The second electrode patterns 503 may have a loop shape in a plan view, and both ends of each of the second electrode patterns 503 may be connected to the electromagnetic sensor driver EIC.

The first electrode patterns 502 intersect the second electrode patterns 503 in a plan view. The first electrode patterns 502 and the second electrode patterns 503 may be driven by the electromagnetic sensor driver EIC to generate a magnetic field or an electromagnetic signal. The touch input member such as an electronic pen may sense a magnetic field or an electromagnetic signal and may emit a radio frequency signal, and the first electrode patterns 502 and the second electrode patterns 503 may receive the radio frequency signal emitted by the touch input member. The electromagnetic sensor driver EIC may determine touch coordinates, a touch angle, and touch pressure by determining the location, angle, and intensity of the radio frequency signal received by the first electrode patterns 502 and the second electrode patterns 503.

According to some embodiments, the first electrode patterns 502 and the second electrode patterns 503 may have a rectangular loop shape in a plan view, but embodiments according to the present disclosure are not limited thereto.

The first dummy patterns 504 may extend in the second direction (or the Y-axis direction) and may be spaced apart from one another in the first direction (or the X-axis direction). According to some embodiments, the distance between first dummy patterns 504 surrounded by one first electrode pattern 502 may be uniform.

The second dummy patterns 505 may extend in the first direction (or the X-axis direction) and may be spaced apart from one another in the second direction (or the Y-axis direction). According to some embodiments, the distance between second dummy patterns 505 surrounded by one second electrode pattern 503 may be uniform.

According to some embodiments, the first electrode patterns 502, the first dummy patterns 504, the second electrode patterns 503, and the second dummy patterns 505 may include a metallic material such as copper, silver, nickel, or tungsten.

The first adhesive layer 506 may cover the first surface of the base layer 501, the first electrode patterns 502, and the first dummy patterns 504. The first cover layer 508 may be arranged on the first adhesive layer 506. The first cover layer 508 may be attached on the first surface of the base layer 501 via the first adhesive layer 506. The first adhesive layer 506 may be a pressure sensitive adhesive. The first cover layer 508 may have flexibility and may include an insulating material. According to some embodiments, the first cover layer 508 may include polyimide.

The second adhesive layer 507 may cover the second surface of the base layer 501, the second electrode patterns 503, and the second dummy patterns 505. The second cover layer 509 may be arranged below the second adhesive layer 507. The second cover layer 509 may be attached on the second surface of the base layer 501 via the second adhesive layer 507. The second adhesive layer 507 may be a pressure sensitive adhesive. The second cover layer 509 may have flexibility and may include an insulating material. According to some embodiments, the second cover layer 509 may include polyimide.

For example, the electromagnetic sensor driver EIC may be embedded in the display device. For another example, the electromagnetic sensor driver EIC may be a set device driving the display device. In this case, a display system may include the display device and a driver, the driver may include the electromagnetic sensor driver EIC.

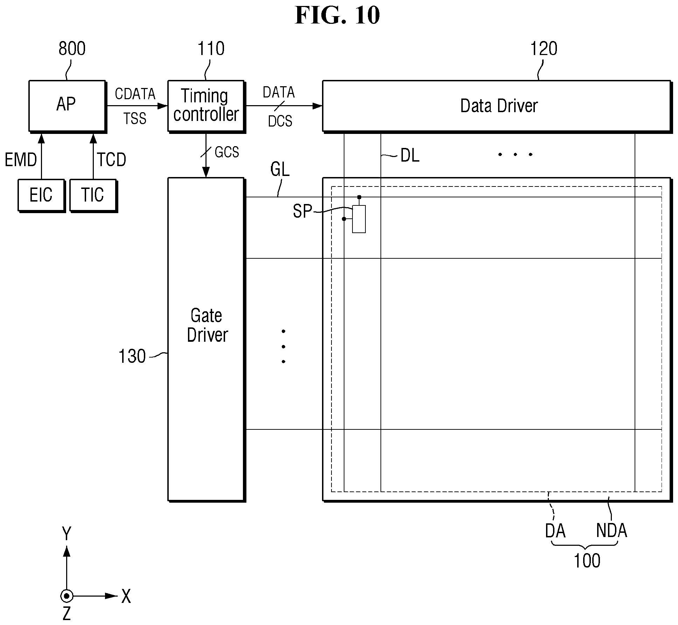

FIG. 10 is a block diagram illustrating a main processor, the electromagnetic sensor driver, the touch driver, and a display driver of the display device of FIG. 1.

Referring to FIG. 10, the display panel 100 may include the display area DA and the non-display area NDA.

The display area DA, which is an area that displays an image, may be defined as a central area of the display panel 100. The display area DA may include a plurality of pixels SP, which are formed in pixel areas that are defined by a plurality of data lines DL and a plurality of gate lines GL. Each of the pixels SP may be connected to at least one gate line GL, a data line DL, and at least one power supply line. The pixels SP may be defined as minimal unit areas that output light to generate images.

The non-display area NDA may surround the display area DA. According to some embodiments, the non-display area NDA may include a gate driver 130, which applies gate signals to the gate lines GL, fan-out lines, which connect the data lines DL and a data driver 120, and a pad unit, which is connected to a circuit board.

The display driver of the display device 10 may include a timing controller 110, the data driver 120, and the gate driver 130. According to some embodiments, the gate driver 130 may be formed as a separate chip from the timing controller 110 and the data driver 120 and may be arranged on one side of the non-display area NDA, but embodiments according to the present disclosure are not limited thereto.

The timing controller 110 may receive pixel data CDATA and timing synchronization signals TSS from a main processor 800 via a user connector provided on the circuit board. Here, the pixel data CDATA may include coordinate data corrected by the main processor 800. The timing controller 110 may provide a data signal DATA, which is generated based on the pixel data CDATA, to the data driver 120. Thus, the display device 10 can display touch information on its screen based on the pixel data CDATA.

The timing controller 110 may generate a data control signal DCS and a gate control signal GCS based on the timing synchronization signal TSS. The timing controller 110 may control the driving timing of the data driver 120 using the data control signal DCS, and may control the driving timing of the gate driver 130 using the gate control signal GCS.

The data driver 120 may be connected to the data lines DL. The data driver 120 may receive the data signal DATA and the data control signal DCS from the timing controller 110. The data driver 120 may generate data voltages based on the data signal DATA and may provide the data voltages to the data lines DL in accordance with the data control signal DCS. The data voltages may be provided to the pixels SP via the data lines DL, and the luminance of the pixels SP may be determined.

The gate driver 130 may be provided in the non-display area NDA of the display panel 100. According to some embodiments, the gate driver 130 may be provided on one side of the non-display area NDA of the display panel 100. The gate driver 130 may generate gate signals in accordance with the gate control signal GCS provided by the timing controller 110 and may sequentially provide the gate signals to the gate lines GL in an order (e.g., a set or predetermined order).

The main processor 800 may provide the pixel data CDATA and the timing synchronization signal TSS to the timing controller 110 so that the display panel 100 may display an image. The main processor 800 may receive first coordinate data EMD of the touch input member from the electromagnetic sensor driver EIC and may receive second coordinate data TCD of the touch input member from the touch driver TIC. According to some embodiments, the electromagnetic sensor driver EIC may generate the first coordinate data EMD by detecting touch input from the touch input member via the first and second digitizer layers 510 and 520, which correspond to the first and second display areas DA1 and DA2, respectively. The touch driver TIC may generate the second coordinate data TCD by detecting touch input from the touch input member via the touch electrodes SEN in each of the first overlapping sensing area DA1H, the second overlapping sensing area DA2H, and the third display area DA3. The main processor 800 may generate corrected coordinate data by comparing the first coordinate data EMD and the second coordinate data TCD and may generate pixel data CDATA including the corrected coordinate data.

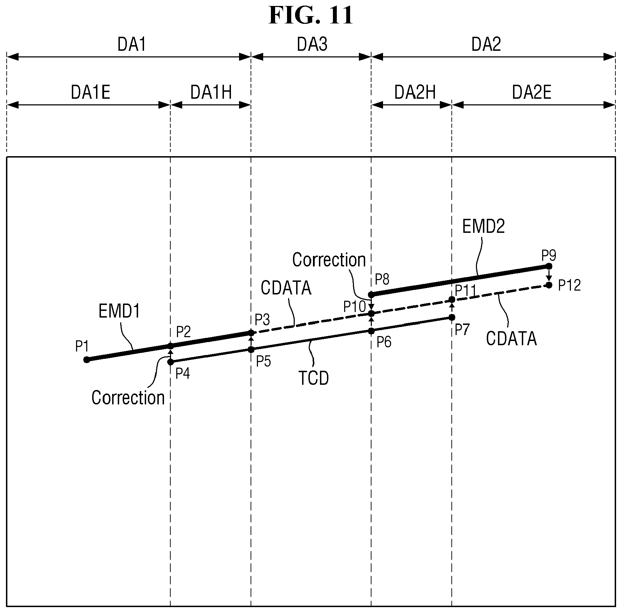

FIG. 11 illustrates how to correct first coordinate data and second coordinate data according to some embodiments of the present disclosure.

Referring to FIG. 11, the main processor 800 may generate corrected coordinate data by comparing the first coordinate data EMD and the second coordinate data TCD and may generate pixel data CDATA including the corrected coordinate data. The main processor 800 may calculate corrected coordinate data by comparing the first coordinate data EMD and the second coordinate data TCD, which are detected from the first and second overlapping sensing areas DA1H and DA2H. According to some embodiments, the electromagnetic sensor driver EIC may generate (1-1)-th coordinate data EMD1 based on touch data detected from the first digitizer layer 510 and may generate (1-2)-th coordinate data EMD2 based on coordinate data detected from the second digitizer layer 520.

In a case where the touch input member is in contact with, or approaches, a first point P1 in the first electromagnetic sensing area DA1E for a first time, the first digitizer layer 510 may detect the touch of the touch input member from the first point P1. In a case where the touch input member moves from the first point P1 to a third point P3, the electromagnetic sensor driver EIC may generate (1-1)-th coordinate data EMD1 indicating that the touch input member has moved from the first point P1 to the third point P3.

In a case where the touch input member passes through a second point P2 between the first electromagnetic sensing area DA1E and the first overlapping sensing area DA1H, the touch sensing layer TSL may detect the touch of the touch input member from the second point P2. In a case where the touch input member passes through the second point P2, the touch driver TIC may generate second coordinate data TCD indicating that the touch input member has passed through the fourth point P4. In this case, there may arise error between the second coordinate data TCD from the touch driver TIC and the (1-1)-th coordinate data EMD1 from the electromagnetic sensor driver EIC. Thus, the main processor 800 may correct the second coordinate data TCD from the touch sensor layer TSL based on the (1-1)-th coordinate data EMD1 from the first digitizer layer 510. The main processor 800 may correct the second coordinate data TCD to indicate that the touch input member has passed through as the second point P2, rather than the fourth point P4.

In a case where the touch input member passes through the third point P3 between the first overlapping sensing area DA1H and the third display area DA3, the touch sensing layer TSL may detect the touch of the touch input member from a fifth point P5. In a case where the touch input member passes through the third point P3, the touch driver TIC may generate second coordinate data TCD indicating that the touch input member has passed through the fifth point P5. In this case, there may arise error between the second coordinate data TCD from the touch driver TIC and corrected coordinate data from the main processor 800. Thus, the main processor 800 may correct the second coordinate data TCD from the touch sensor layer TSL based on the corrected coordinate data. The main processor 800 may correct the second coordinate data TCD to indicate that the touch input member has passed through the third point P3, rather than fifth point P5.

In a case where the touch input member passes through a tenth point P10 between the third display area DA3 and the second overlapping sensing area DA2H, the second digitizer layer 520 may detect the touch of the touch input member from an eighth point P8. In a case where the touch input member passes through the tenth point P10, the electromagnetic sensor driver EIC may generate (1-2)-th coordinate data EMD2 indicating that the touch input member has passed through the eighth point P8. In this case, there may arise error between the (1-2)-th coordinate data EMD2 from the electromagnetic sensor driver EIC and corrected coordinate data from the main processor 800. Thus, the main processor 800 may correct the (1-2)-th coordinate data EMD2 from the electromagnetic sensor driver EIC based on the corrected coordinate data. The main processor 800 may correct the (1-2)-th coordinate data EMD2 to indicate that the touch input member has passed through the tenth point P10, rather than the eighth point P8.

In this manner, the main processor 800 may synchronize the (1-1)-th coordinate data EMD1 from the first digitizer layer 510 and the second coordinate data TCD from the touch sensor layer TSL and synchronize the second coordinate data TCD from the touch sensor layer TSL and the (1-2)-th coordinate data EMD2 from the electromagnetic sensor driver EIC, thereby generating pixel data CDATA including corrected coordinate data of the touch input member, even from the third display area DA3 where the digitizer layer 500 is not arranged. Accordingly, even if the digitizer layer 500 is not provided in a folding area (or the third display area DA3), the display device 10 can improve the touch sensitivity for the touch input member in the folding area.

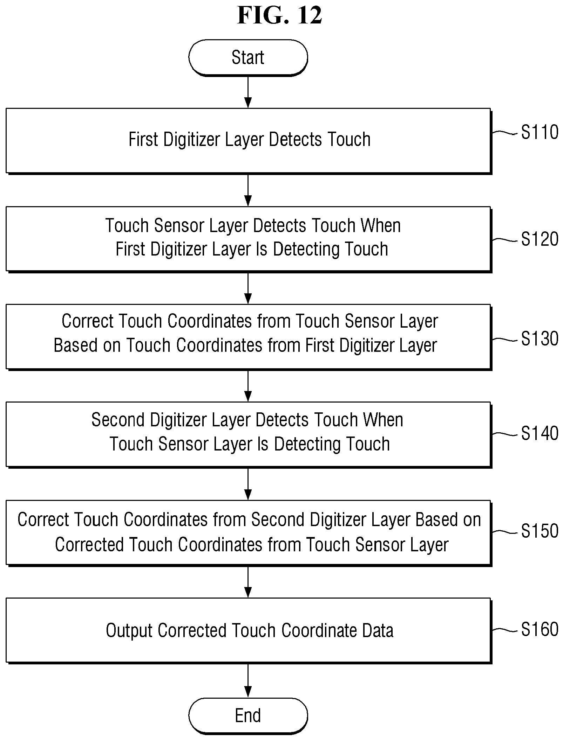

FIG. 12 is a flowchart illustrating how to correct first coordinate data and second coordinate data according to the embodiments described with respect to FIG. 11.

Referring to FIG. 12, in a case where the touch input member is in contact with, or approaches the first point P1 in the first electronic sensing area DA1E for a first time, the first digitizer layer 510 may detect the touch of the touch input member from the first point P1 (S110).

In a case where the touch input member passes through the second point P2 when the first digitizer layer 510 is detecting another touch of the touch input member after the detection of the touch of the touch input member from the first point P1, the touch sensor layer TSL may detect the touch of the touch input member from the fourth point P4 (S120). In this case, there may arise error between the second coordinate data TCD from the touch driver TIC and the (1-1)-th coordinate data EMD1 from the electromagnetic sensor driver EIC.

The main processor 800 may correct the second coordinate data TCD from the touch driver TIC based on the (1-1)-th coordinate data EMD1 from the first digitizer layer 510 (S130).

In a case where the touch input member passes through the tenth point P10 when the first digitizer layer 510 is detecting touch input after the detection of the touch of the touch input member from the fourth point P4, the second digitizer layer 520 may detect the touch of the touch input member from the eighth point P8 (S140). In this case, there may arise error between the (1-2)-th coordinate data EMD2 from the electromagnetic sensor driver EIC and the corrected coordinate data from the main processor 800.

The main processor 800 may correct the (1-2)-th coordinate data EMD2 from the electromagnetic sensor driver EIC based on the corrected coordinate data (S150).

The main processor 800 may output corrected touch coordinate data (S160) by synchronizing the first coordinate data EMD from the digitizer layer 500 and the second coordinate data TCD from the touch sensor layer TSL. According to some embodiments, the main processor 800 may synchronize the (1-1)-th coordinate data EMD1 from the first digitizer layer 510 and the second coordinate data TCD from the touch sensor layer TSL and synchronize the second coordinate data TCD from the touch sensor layer TSL and the (1-2)-th coordinate data EMD2 from the electromagnetic sensor driver EIC, thereby generating pixel data CDATA including corrected coordinate data of the touch input member.

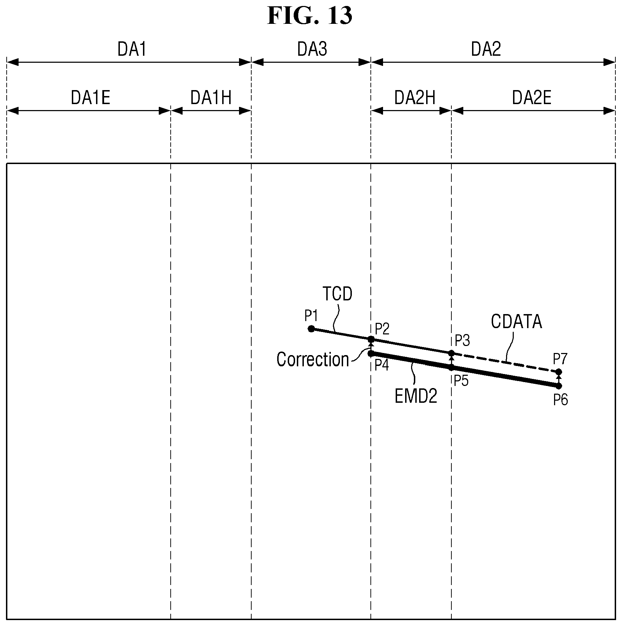

FIG. 13 illustrates how to correct first coordinate data and second coordinate data according to some embodiments of the present disclosure.

Referring to FIG. 13, in a case where the touch input member is in contact with, or approaches, a first point P1 in the third display area DA3 for a first time, the touch sensor layer TSL may detect the touch of the touch input member from the first point P1. In a case where the touch input member moves from the first point P1 to a third point P3, the touch driver TIC may generate second coordinate data TCD indicating that the touch input member has moved from the first point P1 to the third point P3.

In a case where the touch input member passes through a second point P2 between the third display area DA3 and the second overlapping sensing area DA2H, the second digitizer layer 520 may detect the touch of the touch input member from the fourth point P4. In a case where the touch input member passes through the second point P2, the electromagnetic sensor driver EIC may generate (1-2)-th coordinate data EMD2 indicating that the touch input member has passed through a fourth point P4. In this case, there may arise error between the second coordinate data TCD from the touch driver TIC and the (1-2)-th coordinate data EMD2 from the electromagnetic sensor driver EIC. Thus, the main processor 800 may correct the (1-2)-th coordinate data EMD2 from the second digitizer layer 520 based on the second coordinate data TCD from the touch driver TIC. The main processor 800 may correct the (1-2)-th coordinate data EMD2 to indicate that the touch input member has passed through as the second point P2, rather than the fourth point P4.

In this manner, the main processor 800 may synchronize the second coordinate data TCD from the touch sensor layer TSL and the (1-2)-th coordinate data EMD2 from the electromagnetic sensor driver EIC, thereby generating pixel data CDATA including corrected coordinate data of the touch input member, even from the third display area DA3 where the digitizer layer 500 is not arranged. Accordingly, even if the digitizer layer 500 is not provided in the folding area (or the third display area DA3), the display device 10 can improve the touch sensitivity for the touch input member.

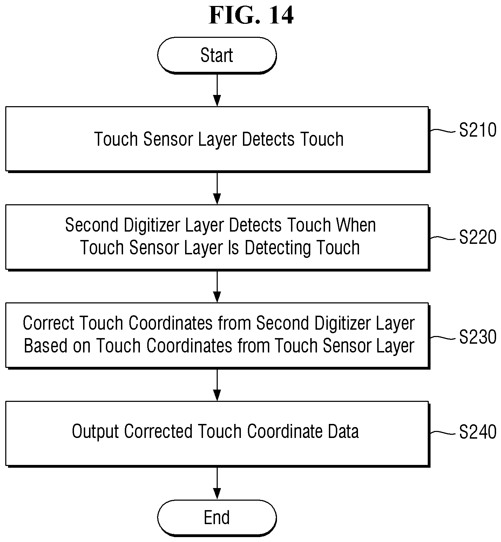

FIG. 14 is a flowchart illustrating how to correct first coordinate data and second coordinate data according to the embodiments described with respect to FIG. 13.

Referring to FIG. 14, in a case where the touch input member is in contact with, or approaches, the first point P1 in the third display area DA3 for a first time, the touch sensor layer TSL may detect the touch of the touch input member from the first point P1 (S210).

In a case where the touch input member passes through the second point P2 when the touch sensor layer TSL is detecting another touch of the touch input member after the detection of the touch of the touch input member from the first point P1, the second digitizer layer 520 may detect the touch of the touch input member from the fourth point P4 (S220). In this case, there may arise error between the second coordinate data TCD from the touch driver TIC and the (1-2)-th coordinate data EMD2 from the electromagnetic sensor driver EIC.

The main processor 800 may correct the (1-2)-th coordinate data EMD2 from the second digitizer layer 520 based on the second coordinate data TCD from the touch sensor layer TSL (S230).

The main processor 800 may output corrected touch coordinate data (S240) by synchronizing the first coordinate data EMD from the digitizer layer 500 and the second coordinate data TCD from the touch sensor layer TSL. Accordingly, even if the digitizer layer 500 is not provided in the folding area (or the third display area DA3), the display device 10 can improve the touch sensitivity for the touch input member in the folding area.

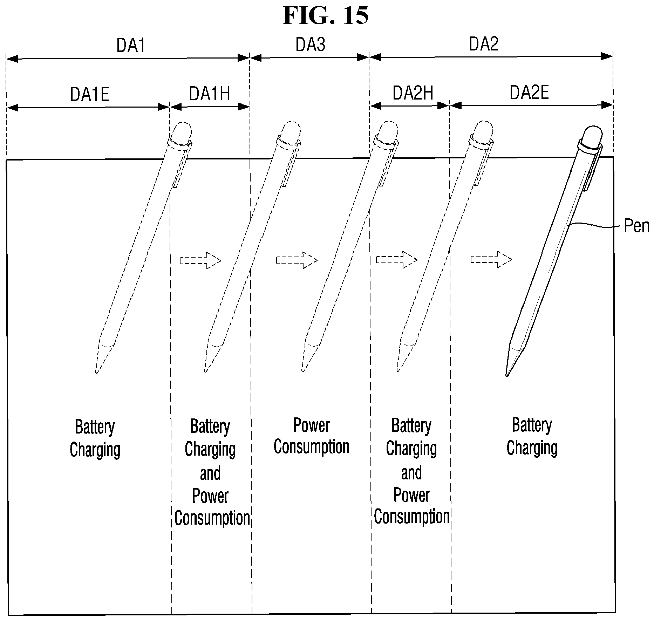

FIG. 15 illustrates how the touch input member of the display device of FIG. 1 has its battery charged and consumes power.

Referring to FIG. 15, a touch input member "Pen" may be a stylus pen that supports EMR using a plurality of electrode patterns.

The touch input member "Pen" may include a coil and may output a radio frequency signal in response to a magnetic field or an electromagnetic signal.

The touch input member "Pen" may further include a battery. The battery of the touch input member "Pen" may be charged in the first and second display areas DA1 and DA2 ("Battery Charging"). The battery of the touch input member "Pen" may consume power in the first and second overlapping sensing areas DA1H and DA2H and the third display area DA3 ("Power Consumption").

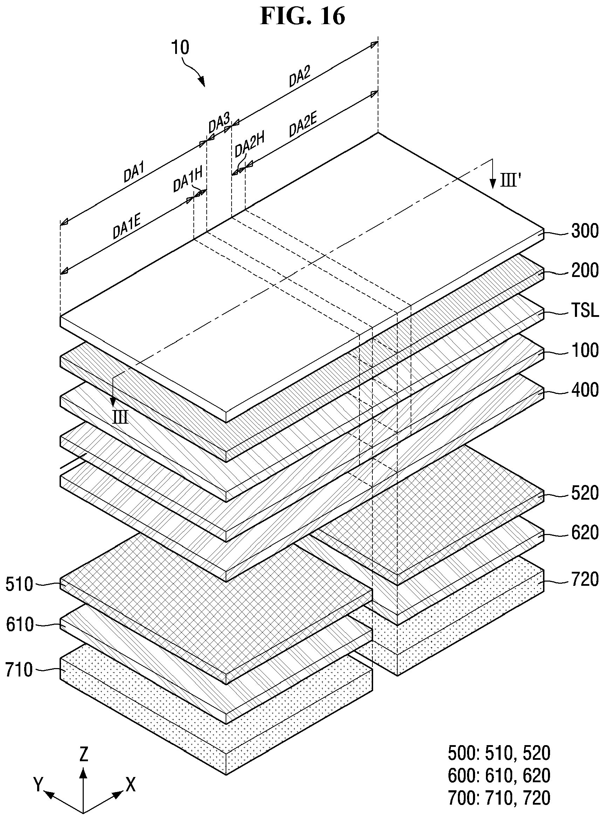

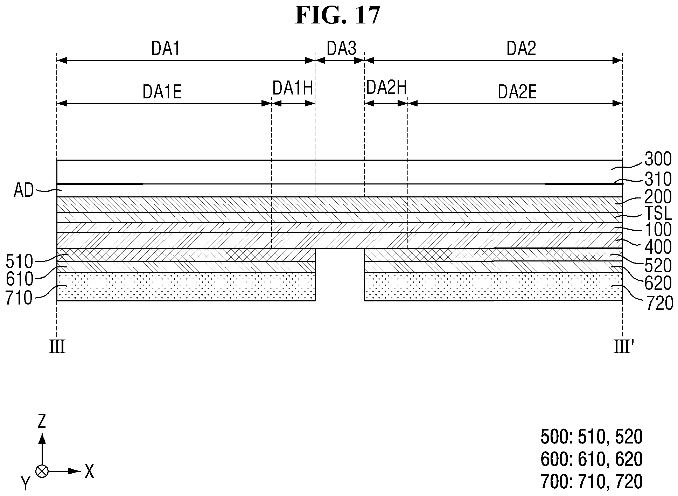

FIG. 16 is an exploded perspective view of a display device according to some embodiments of the present disclosure, and FIG. 17 is a cross-sectional view taken along the line III-III' of FIG. 16. Descriptions of elements or features that have already been described above will be omitted or simplified.

Referring to FIGS. 16 and 17, a display device 10 includes a display panel 100, a touch sensor layer TSL, a polarizing film 200, a cover window 300, a panel protection film 400, a digitizer layer 500, a shielding member 600, and a heat dissipation member 700.

The display panel 100 may include first, second, and third display areas DA1, DA2, and DA3. The display panel 100 may display an image through the first, second, and third display areas DA1, DA2, and DA3.

The display panel 100 may be a light-emitting display panel including light-emitting elements. According to some embodiments, the display panel 100 may be an organic light-emitting display panel, a micro-light-emitting display panel, a quantum-dot light-emitting display panel, or an inorganic light-emitting display panel.

The touch sensor layer TSL may be located on the display panel 100. The touch sensor layer TSL may include a plurality of driving electrodes TE and a plurality of sensing electrodes RE. The driving electrodes TE and the sensing electrodes RE may form mutual capacitance or self-capacitance to detect the touch of an object or a user. According to some embodiments, the driving electrodes TE may receive touch driving signals from a touch driver TIC, and the sensing electrodes RE may provide touch sensing signals to the touch driver TIC.

Alternatively, the touch sensor layer TSL may be located between the polarizing film 200 and the cover window 300. The location of the touch sensor layer TSL is not particularly limited.

The polarizing film 200 may be located on the touch sensor layer TSL. According to some embodiments, the polarizing film 200 may include a linear polarizing plate and a phase retardation film such as a quarter wave (λ/4) plate. The phase retardation film and the linear polarizing plate may be sequentially stacked on the touch sensor layer TSL.

The cover window 300 may be located on the polarizing film 200. The cover window 300 may be attached on the top surface of the polarizing film 200 via an adhesive member AD. According to some embodiments, the adhesive member AD may include a transparent material such as glass or plastic.

The cover window 300 may include a light-blocking layer 310, which is arranged along the edges of the bottom surface of the cover window 300. The light-blocking layer 310 may include a light-blocking material and may thus block light. According to some embodiments, the light-blocking layer 310 may include an inorganic black pigment such as carbon black or an organic black pigment.

The panel protection film 400 may be located below the display panel 100. According to some embodiments, the panel protection film 400 may be located below the display panel 100 to overlap with the first, second, and third display areas DA1, DA2, and DA3. According to some embodiments, the panel protection film 400 may be located only in the first and second display areas DA1 and DA2 so that the display panel 100 may be smoothly foldable.

The digitizer layer 500 may be located below the panel protection film 400. The digitizer layer 500 may include first and second digitizer layers 510 and 520. The first digitizer layer 510 may be located below the panel protection film 400 to overlap with the first display area DA1, and the second digitizer layer 520 may be located below the panel protection film 400 to overlap with the second display area DA2. Thus, as the first and second digitizer layers 510 and 520 are spaced apart from each other by the third display area DA3, the folding stress of the display device 10 can be reduced. Each of the first and second digitizer layers 510 and 520 may be attached to the bottom of the panel protection film 400 via an OCA film or an OCR.

Each of the first and second digitizer layers 510 and 520 may include a plurality of electrode patterns. Each of the first and second digitizer layers 510 and 520 may detect the approach or contact of a touch input member such as stylus pen that supports EMR using a plurality of electrode patterns. Here, the stylus pen may include a coil and may output a radio frequency signal in response to a magnetic field or an electromagnetic signal.

According to some embodiments, each of the first and second digitizer layers 510 and 520 may generate a magnetic field or an electromagnetic signal on the front surface of the display device 10, and the touch input member may detect the magnetic field or the electromagnetic signal and emit a radio frequency signal. Each of the first and second digitizer layers 510 and 520 may detect touch coordinates, a touch angle, and touch pressure by receiving a radio frequency signal upon the approach or contact of the touch input member.

The shielding member 600 may be located below the digitizer layer 500. The shielding member 600 may include first and second shielding members 610 and 620. The first shielding member 610 may be located below the first digitizer layer 510 to overlap with the first display area DA1, and the second shielding member 620 may be located below the second digitizer layer 520 to overlap with the second display area DA2. Thus, as the first and second shielding members 610 and 620 are spaced apart from each other by the third display area DA3, the folding stress of the display device 10 can be reduced.

Each of the first and second shielding members 610 and 620 may include magnetic metal powder and may thus induce a magnetic field or an electromagnetic signal passing through the digitizer layer 500 into the first and second shielding members 610 and 620. Accordingly, the first and second shielding members 610 and 620 can reduce the emission of a magnetic field or an electromagnetic signal to the bottoms of the first and second shielding members 610 and 620.

The heat dissipation member 700 may be located below the shielding member 600. The heat dissipation member 700 may include first and second heat dissipation members 710 and 720. The first heat dissipation member 710 may be located below the first shielding member 610 to overlap with the first display area DA1, and the second heat dissipation member 720 may be located below the second shielding member 620 to overlap with the second display area DA2. Thus, as the first and second heat dissipation members 710 and 720 are spaced apart from each other by the third display area DA3, the folding stress of the display device 10 can be reduced.

Each of the first and second heat dissipation members 710 and 720 may include a film of a metal with excellent thermal conductivity such as copper, nickel, ferrite, or silver. Thus, heat generated by the display device 10 can be released to the outside of the display device 10 by the first and second heat dissipation members 710 and 720.

The characteristics of embodiments according to the present disclosure are not limited by the content described above, and more various characteristics are included in the present specification.

In concluding the detailed description, those skilled in the art will appreciate that many variations and modifications can be made to the example embodiments without departing from the principles of the present invention. Therefore, the disclosed embodiments of the invention are used in a generic and descriptive sense only and not for purposes of limitation.

## Claims

1. A display apparatus comprising:
a display panel (100) comprising a display layer (DPL) having a first display area (DA1), a second display area (DA2) spaced apart from the first display area (DA1), and a third display area (DA3) between the first and second display areas (DA2), and
a touch sensor layer (TSL) on or in the display panel (100) having a plurality of touch electrodes (SEN) overlapping with the first, second, and third display areas (DA1, DA2, DA3) of the display layer (DPL);
a touch driver (TIC) configured to drive the touch electrodes (SEN) of the touch sensor layer (TSL);
a digitizer layer (500) below the display panel (100) and overlapping with the first and second display areas (DA1, DA2), the digitizer layer (500) comprising first electrode patterns (502) and second electrode patterns (503); and
an electromagnetic sensor driver (EIC) configured to drive the first electrode patterns (502) and the second electrode patterns (503) of the digitizer layer (500) to form a magnetic field in the digitizer layer (500).

2. The display apparatus of claim 1, further comprising:
a main processor (800) configured to compare first coordinate data (EMD) of a touch input member (Pen), which is output from the electromagnetic sensor driver (EIC), and second coordinate data (TCD) of the touch input member (Pen), which is output from the touch driver (TIC) to generate corrected coordinate data.

3. The display apparatus of claim 2, wherein the main processor (800) is configured to compare first coordinate data (EMD) detected from a first overlapping sensing area (DA1H), which is part of the first display area (DA1) adjacent to the third display area (DA3), or detected from a second overlapping sensing area (DA2H), which is part of the second display area (DA2) adjacent to the third display area (DA3), and the second coordinate data (TCD) to generate the corrected coordinate data.

4. The display apparatus of claim 3, wherein in response to the electromagnetic sensor driver (EIC) outputting first coordinate data (EMD) from a first electromagnetic sensing area (DA1E), which accounts for an entirety of the first display area (DA1) except for the first overlapping sensing area (DA1H), and then the touch driver (TIC) outputs second coordinate data (TCD) from the first overlapping sensing area (DA1H), the main processor (800) is configured to correct the second coordinate data (TCD) based on the first coordinate data (EMD).

5. The display apparatus of claim 4, wherein in response to the main processor (800) generating corrected coordinate data from the first overlapping sensing area (DA1H) and then the touch driver (TIC) outputs second coordinate data (TCD) from the third display area (DA3), the main processor (800) is configured to correct the second coordinate data (TCD) based on the corrected coordinate data,
wherein in response to the main processor (800) generating corrected coordinate data from the third display area (DA3) and then the electromagnetic sensor driver (EIC) outputting first coordinate data (EMD) from the second overlapping sensing area (DA2H), the main processor (800) is configured to correct the first coordinate data (EMD) based on the corrected coordinate data.

6. The display apparatus of at least one of claims 3 to 5, wherein in response to the touch driver (TIC) outputting second coordinate data (TCD) from the third display area (DA3) and then the electromagnetic sensor driver (EIC) outputting first coordinate data (EMD) from the second overlapping sensing area (DA2H), the main processor (800) is configured to correct the first coordinate data (EMD) based on the second coordinate data (TCD),
wherein in response to the main processor (800) generating corrected coordinate data from the second overlapping sensing area (DA2H) and then the electromagnetic sensor driver (EIC) outputting first coordinate data (EMD) from a second electromagnetic sensing area (DA2E), which accounts for an entirety of the second display area (DA2) except for the second overlapping sensing area (DA2H), the main processor (800) is configured to correct the first coordinate data (EMD) based on the corrected coordinate data.

7. The display apparatus of at least one of claims 1 to 6, wherein
the touch electrodes (SEN) comprise a plurality of driving electrodes (TE) and a plurality of sensing electrodes (RE) insulated from the driving electrodes (TE),
the first display area (DA1) comprises a first overlapping sensing area (DA1H) adjacent to the third display area (DA3), and a first electromagnetic sensing area (DA1E), which accounts for an entirety of the first display area (DA1) except for the first overlapping sensing area (DA1H),
the second display area (DA2) comprises a second overlapping sensing area (DA2H) adjacent to the third display area (DA3), and a second electromagnetic sensing area (DA2E), which accounts for an entirety of the second display area (DA2) except for the second overlapping sensing area (DA2H), and
the touch sensor layer (TSL) comprises:
first touch driving lines (TL1) connected between the touch driver (TIC) and driving electrodes (TE) in the first electronic sensing area;
second touch driving lines (TL2) connected between the touch driver (TIC) and driving electrodes (TE) in the second electromagnetic sensing area (DA2E); and
third touch driving lines (TL3) connected between the touch driver (TIC) and driving electrodes (TE) in each of the first overlapping sensing area (DA1H), the second overlapping sensing area (DA2H), and the third display area (DA3).

8. The display apparatus of claim 7, wherein
the touch driver (TIC) is configured to provide first touch driving signals to the first touch driving lines (TL1), the second touch driving lines (TL2), and the third touch driving lines (TL3) to detect a touch of a user, and
the touch driver (TIC) is configured to provide second touch driving signals to the third touch driving lines (TL3) to detect a touch of the touch input member (Pen).

9. The display apparatus of at least one of claims 1 to 8,
wherein
the first display area (DA1) comprises a first overlapping sensing area (DA1H) adjacent to the third display area (DA3), and a first electromagnetic sensing area (DA1E), which accounts for an entirety of the first display area (DA1) except for the first overlapping sensing area (DA1H),
the second display area (DA2) comprises a second overlapping sensing area (DA2H) adjacent to the third display area (DA3), and a second electromagnetic sensing area, which accounts an entirety of the second display area (DA2) except for the second overlapping sensing area (DA2H),
the electromagnetic sensor driver (EIC) is configured to detect a touch of a touch input member (Pen) from the first and second display areas (DA2), and
the touch driver (TIC) is configured to detect a touch of the touch input member (Pen) from the first overlapping sensing area (DA1H), the second overlapping sensing area (DA2H), and the third display area (DA3).

10. The display apparatus of claim 9, further comprising:
a main processor (800) configured to compare first coordinate data (EMD) from the first and second overlapping sensing areas (DA1H, DA2H), which is output from the electromagnetic sensor driver (EIC), and second coordinate data (TCD) from the first and second overlapping sensing areas (DA1H, DA2H), which is output from the touch driver (TIC) to generate corrected coordinate data.

11. The display apparatus of claim 10, wherein in response to the electromagnetic sensor driver (EIC) outputting first coordinate data (EMD) from the first electromagnetic sensing area (DA1E) and then the touch driver (TIC) outputting second coordinate data (TCD) from the first overlapping sensing area (DA1H), the main processor (800) is configured to correct the second coordinate data (TCD) based on the first coordinate data (EMD).

12. The display apparatus of claim 11, wherein in response to the main processor (800) generating corrected coordinate data from the first overlapping sensing area (DA1H) and then the touch driver (TIC) outputting second coordinate data (TCD) from the third display area (DA3), the main processor (800) is configured to correct the second coordinate data (TCD) based on the corrected coordinate data,
wherein in response to the main processor (800) generating corrected coordinate data from the third display area (DA3) and then the electromagnetic sensor driver (EIC) outputting first coordinate data (EMD) from the second overlapping sensing area (DA2H), the main processor (800) is configured to correct the first coordinate data (EMD) based on the corrected coordinate data.

13. The display apparatus of at least one of claims 1 to 12, comprising:
a display device (10) displaying an image;
wherein the display device (10) comprises the display panel (100), the digitizer layer (500), the touch driver (TIC), and the electromagnetic sensor driver (EIC).

14. The display apparatus of at least one of claims 1 to 12, comprising:
a display device (10) displaying an image; and
a driver driving the display device (10),
wherein the display device (10) comprises the display panel (100), and the digitizer layer (500), and
wherein the driver comprises the touch driver (TIC) and the electromagnetic sensor driver (EIC).

15. The display apparatus of at least one of claims 1 to 14, wherein the display panel (100) is bendable and/or foldable in the third display area (DA3) and non-bendable and/or non-foldable in the first display area (DA1) and second display area (DA2).
